(19) 

Europäisches Patentamt

European Patent Office

Office européen des brevets

(11) **EP 4 672 604 A1**

(12) **EUROPEAN PATENT APPLICATION**

(43) Date of publication:
**31.12.2025 Bulletin 2026/01**

(21) Application number: 24306030.8

(22) Date of filing: **26.06.2024**

(51) International Patent Classification (IPC):
**H03K 5/24** *(2006.01)* **H03F 3/45** *(2006.01)*

(52) Cooperative Patent Classification (CPC):
**H03K 5/2481; H03F 3/45475**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Scalinx**
**75013 Paris (FR)**

(72) Inventors:
• **GUIRAUD, Lionel**
**14750 St Aubin Sur Mer (FR)**
• **BOIRON, Marc**
**14220 Barbery (FR)**

(74) Representative: **Murgitroyd & Company**
**165-169 Scotland Street**
**Glasgow G5 8PL (GB)**

(54) **CURRENT COMPARATOR CIRCUIT AND METHOD**

(57) A current comparator circuit and method. The circuit includes a first input and a second input to receive currents $I_1$, and $I_2$. The circuit includes a current-to-voltage converter and a switch. The circuit includes a first and second current branches comprising a current input terminals coupled to the first input and the second input. In a first mode the switch is closed to cause an input voltage at the first input and at the second input to be equal. In a second mode the switch is opened whereby a current flows through the current-to-voltage converter and voltage $\Delta V$ appears across the first input and the second input. In both the first mode and the second mode, the current flowing through the first branch and the current flowing through the second branch are equal to $(I_1 + I_2)/2$.

Fig. 1

**Description**

FIELD

The present specification relates to a current comparator circuit and method. The present specification also relates to a digital to analogue converter including a current comparator circuit.

BACKGROUND

The main operation of a digital to analogue converter (DAC) is to output an analogue current or voltage based on the value of a digital input. In the case of the current mode DAC, the output current is the sum of the output of unit current sources. Each unit current source is controlled by the digital input value. The digital input is usually binary coded and thus consists of a set of bits. The current sources can be built in a binary coding mode where the value of each current source evolves with a binary weight (power of 2) or in a thermometer coding mode where each of the current sources has the same value. The thermometer coding mode is preferred when an accurate digital to analogue conversion is required. To achieve high accuracy over the full range of code, it is necessary to perform a calibration of the current sources to compensate for the variation of each individual current source (mismatch). This is done by comparing the output current of each of the current source to a target current and adjusting the output current based on the output of the comparison. The calibration process requires thus a highly accurate current comparator.

US 5,446,397 describes that current output terminals of first and second current mirror circuits are connected. An input terminal of a third current mirror circuit is connected to a node of the current output terminals of the first and second current mirror circuits. A load circuit is connected between a current output terminal of the third current mirror circuit and a first voltage. An output terminal is connected to the load circuit. First and second currents to be compared with each other are supplied to current input terminal of the first and second current mirror circuits.

US 5,770,954 describes a method and a respective circuit arrangement capable of limiting the absorption of current by a current comparator circuit. The method consists in limiting the absorption of current through the branch of the comparator circuit, along which is forced the highest current to the value of the lowest current, which is in turn forced through the other branch of the comparator circuit. This condition is obtained without interfering in any way with other characteristics of switching speed and sensitivity of the comparator circuit.

US 6,275,075 describes a current comparator that reduces both input and output resistance. The current comparator positions a resistive feedback network in a first inverting amplifier of an input stage. The input stage according to the present invention can include a first and a second input terminal, an output terminal, a reference current source, a load circuit, a driving unit, and a resistive circuit. The reference current source supplies a reference current to the first input terminal. The load circuit supplies a first current to the output terminal. The first current is preferably equal to the reference current. The driving unit generates a prescribed output voltage by controlling the first current based on an input current applied to the second input terminal. The resistor is coupled between a control terminal of the driving unit, the second input terminal and the output terminal.

US 6,424,183 describes a current comparator comprising a first CMOS transistor, a second CMOS transistor, a diode-configured N-type transistor, a fourth CMOS transistor and a fifth CMOS transistor.

US 7,583,108 describes a current comparator that includes an input node for receiving an input current, an output node, a first wide swing current mirror having an input coupled to the input node of the current comparator, a power node for receiving a first power supply voltage such as ground, and an output coupled to the output node of the current comparator, and a second wide swing current mirror having an input coupled to the input node of the current comparator, a power node for receiving a second power supply voltage such as VDD, and an output coupled to the output node of the current comparator. The output node can provide either a voltage or current output signal.

US 9,841,443 describes a detection circuit for detecting an external device with a specific resistance. The detection circuit includes a first resistor, a second resistor, a first converter, a second converter, a device converter, a first current comparator, and a second current comparator. The first resistor has a first resistance. The second resistor has a second resistance. The first converter is configured to convert the first resistance into a first current. The second converter is configured to convert the second resistance into a second current. The device converter is configured to convert the specific resistance into a specific current. The first current comparator is configured to compare the specific current with the first current and generate a first output signal. The second current comparator is configured to compare the specific current with the second current and generate a second output signal.

"1.5GHz fully differential latched current comparator with 20mA of sensitivity", V. Giannini, J. Craninckx, B. Come, P. Malcovati, A. Baschirotto, 2006 Ph.D. Research in Microelectronics and Electronics (IEEE) describes that current comparison becomes critical in those data conversion systems where it is highly desirable to achieve speed without sacrificing either accuracy or power consumption. A circuital solution is described to perform current comparison at very high speed. The comparator consists of a fully differential class-AB current input stage, two regenerative flip-flops, and an SR latch.

"500MHz differential latched current comparator for calibration of current steering DAC", Santanu Sarkar, Swapna Banerjee, Proceedings of the 2014 IEEE Students' Technology Symposium, describes design techniques of a high performance current comparator which can sense a minimum change of 8 nA for 10 μA input current. The current comparator shows fast response with 0.95 ns delay for an input current difference of 0.1 μA peak-to-peak and it can work up to 500 MHz clock frequency. The use of low impedance trans-impedance stage makes it faster and the preamplifier removes kickback noise. Using latch at the end of comparator provides a faster response. The dynamic comparator is precharged to VDD during low clock phase to remove the memory effects. The current comparator has been designed in 180 nm CMOS process with 1.8 V supply.

"A full differential low voltage low power high speed current comparator", G. Roientan Lahiji, F. Rezvan, ICM 2000. Proceedings of the 12th International Conference on Microelectronics (IEEE), describes a full differential low-voltage, low-power, and high-speed CMOS current comparator.

"Differential Input Area Efficient Current Comparator", A. R. Serazetdinov and E. V. Atkin, Proceedings 2019 IEEE 31st International Conference on Microelectronics (MIEL), Nis, Serbia, September 16-18, 2019, describes a differential input area efficient current comparator for multichannel detector (sensor) applications. The comparator consists of current preamplifier, hysteresis latch, amplifier-voltage limiter and output low-voltage to CMOS translator, having built-in polarity selection switch. The latch geometry was chosen to feature non-zero hysteresis and minimum size.

"CMOS Latch Based on a Class-AB Transconductor", Carlos A. de la Cruz Blas et al., 2011 20th European Conference on Circuit Theory and Design (ECCTD), describes a novel CMOS latch designed using a class-AB transconductor as a core.

Aspects of the present disclosure are set out in the accompanying independent and dependent claims. Combinations of features from the dependent claims may be combined with features of the independent claims as appropriate and not merely as explicitly set out in the claims.

According to an aspect of the present disclosure, there is provided a current comparator circuit according to claim 1.

In some embodiments, the current-to-voltage converter and the switch are coupled in parallel between the first input and the second input.

In some embodiments, the current-to-voltage converter comprises a first current-to-voltage converter component coupled to the first input and a second current-to-voltage converter component coupled to the second input.

In some embodiments:

the first current branch comprises a first current conveyor and a second current conveyor;
the second current branch comprises a third current conveyor and a fourth current conveyor;
wherein each current conveyor comprises a current input terminal, a current output terminal, and a control terminal, wherein a current flowing through each current conveyor is controllable by a voltage applied to the control terminal of that current conveyor,
wherein:

the control terminal and the current input terminal of the first current conveyor is coupled to the first input;
the control terminal of the second current conveyor is coupled to the second input;
the current input terminal of the second current conveyor is coupled to the first input;
the control terminal of the third current conveyor is coupled to the first input;
the current input terminal of the third current conveyor is coupled to the second input, and
the control terminal and the current input terminal of the fourth current conveyor is coupled to the second input,

wherein in the first mode:

$$V_{C1a} = V_{C1b} = V_{C2a} = V_{C2b} \;;$$

and

$$I_{1a} = I_{1b} = I_{2a} = I_{2b} = I_{CM}/2 = (I_1+I_2)/4$$

where $I_{1a}$, $I_{1b}$, $I_{2a}$, $I_{2b}$ are the currents flowing through the first, second, third and fourth current conveyors, respectively, and where $V_{C1a}$, $V_{C1b}$, $V_{C2a}$, and $V_{C2b}$ are voltages applied to the control terminals of the first, second, third and fourth current conveyors, and
wherein, in the second mode :

$\Delta V = 0$ is indicative of $I_1$ being equal to $I_2$ and wherein $\Delta V \neq 0$ is indicative of $I_1$ not being equal to $I_2$;

$V_{inm} = V_{incm} + \Delta V/2$, whereby $V_{C1a}$ and $V_{C2a}$ vary by $+\Delta V/2$ which creates changes $\delta I_{1a}$ and $\delta I_{2a}$ in $I_{1a}$ and $I_{2a}$ proportional to $+\Delta V/2$;

$V_{inp} = V_{incm} - \Delta V/2$, whereby $V_{C1b}$ and $V_{C2b}$ vary by $-\Delta V/2$ which creates changes $\delta I_{1b}$ and $\delta I_{2b}$ in $I_{1b}$ and $I_{2b}$ proportional to $-\Delta V/2$;

where $\delta I_{1a} = -\delta I_{1b}$ and where $\delta I_{2a} = -\delta I_{2b}$, whereby $I_{1a} + I_{1b} = I_{2a} + I_{2b} = I_{CM}$;

$$\Delta I = I_1 - (I_{1a} + I_{1b}) = I_1 - I_{CM} = I_1 - (I_1 + I_2)/2 = (I_1 - I_2)/2 \; ;$$

and

$$\Delta I = - I_2 + (I_{2a} + I_{2b}) = -I_2 + I_{CM} = -I_2 + (I_1 + I_2)/2 = (I_1 - I_2)/2 \; ,$$

where $I_{CM}$ is a common mode current of the first input and the second input.

The current output terminal of each current conveyor may be coupled to a reference potential. The reference potential may be a common reference potential. The reference potential may be ground.

The first current may be a reference current and the second current may be a current to be calibrated against the reference current.

Each current conveyor may have substantially the same voltage-to-current gain characteristic.

The current comparator circuit may further include a voltage amplifier coupled across the first input and the second input for determining $\Delta V$ in the second mode.

Each current conveyor may comprise a transistor. The control terminal of the current conveyor may comprise a gate of the transistor. The current input terminal of the current conveyor may comprise a drain of the transistor.

Each current conveyor may further comprise a resistor coupled to a source of the transistor.

In the second mode, in which the switch is open, a difference in current between the current received at the first input and the current received at the second input may flow through the current-to-voltage converter.

In the first mode, in which the switch is closed, each of the four current conveyor may drive a current substantially equal to the sum of the currents received at the first and second input divided by four.

The current-to-voltage converter or each current-to-voltage converter component may comprise one of:

a capacitor;
a resistor, and
a capacitor in parallel with a resistor.

According to another aspect of the present disclosure, there is provided a digital to analogue converter according to claim 14.

According to a further aspect of the present disclosure, there is provided a method according to claim 15.

BRIEF DESCRIPTION OF THE DRAWINGS

Embodiments of this disclosure will be described hereinafter, by way of example only, with reference to the accompanying drawings in which like reference signs relate to like elements and in which:

Figure 1 shows a current comparator circuit according to an embodiment of this disclosure;
Figure 2 illustrates a first mode in the operation of the current comparator circuit of Figure 1, according to an embodiment of this disclosure;
Figure 3 illustrates a second mode in the operation of the current comparator circuit of Figure 1, according to an embodiment of this disclosure;
Figure 4A and 4B illustrate single-ended and differential equivalence in a current comparator circuit according to an embodiment of this disclosure; and
Figure 5 shows a current comparator circuit according to an embodiment of this disclosure.

DETAILED DESCRIPTION

Embodiments of this disclosure are described in the following with reference to the accompanying drawings.

**EP 4 672 604 A1**

The main operation of a digital to analogue converter, D/A, converter (DAC) is to output an analogue current or voltage based on the value of a digital input. In case of a current mode DAC, the output current may be the sum of the output of unit current sources. Each unit current source may be controlled by the digital input value. The digital input is usually binary coded and thus consists of a set of bits. The current sources can be built in a binary coding mode, where the value of each current source evolves with a binary weight (power of 2) or in a thermometer coding mode where each of the current sources has the same value. The thermometer coding mode is often preferred when an accurate D/A conversion is required. To achieve high accuracy over the full range of codes, a calibration of the current sources can be performed, so as to compensate for the variation of each individual current source (e.g., mismatches caused by temperature or manufacturing variations). This can be done by comparing the output current of each of the current source to a target (reference) current and adjusting the output current based on the output of the comparison. The calibration process requires thus a highly accurate current comparator.

Embodiments of this disclosure can provide a current comparator circuit in which an auto-biasing scheme may be used without the need of a feedback loop. Embodiments of this disclosure can also provide a current comparator circuit with an improved capability to discriminate a very low current difference in the comparison, by offering a high gain comparator which is not sensitive to charge injection from a reset switch. Accordingly, Embodiments of this disclosure can provide a flexible, accurate and fast current comparator and can allow for swift and accurate calibration of a set of current sources of a DAC.

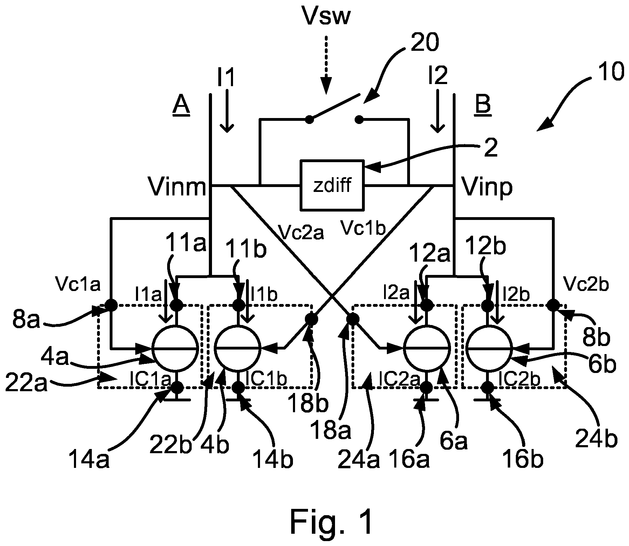

Figure 1 shows a current comparator circuit 10 according to an embodiment of this disclosure. The current comparator circuit 10 includes a first current input A. The first input A is operable to receive a first current $I_1$. The current comparator circuit 10 also includes a second current input B. The second input B is operable to receive a first current $I_2$. As will be described below, the current comparator circuit 10 is operable to compare the input currents $I_1$, $I_2$.

In one embodiment, the first current $I_1$ is a reference current, and the second current $I_2$ is a current which is to be calibrated against the reference current. This arrangement may, for instance be implemented in a digital to analogue converter, DAC. In one embodiment, the DAC may include a plurality of current sources and at least one current comparator circuit 10 of the kind described herein. The at least one current comparator circuit 10 may be used to calibrate the current sources of the DAC (e.g., the outputs of the current sources may correspond to $I_2$ and can be calibrated by comparing them to one or more reference currents $I_1$ and adjusting them accordingly).

In operation, a differential voltage will be generated at the inputs A, B by the circuit 10 in relation to a difference between the input currents $I_1$ and $I_2$. The inputs A, B can act at the same time as current inputs receiving the currents to be compared (i.e., $I_1$, $I_2$) and as voltage outputs that provide information on the difference between the input currents $I_1$, $I_2$.

The current comparator circuit 10 also includes a current-to-voltage converter 2. The current-to-voltage converter 2 may be considered to be a differential current-to-voltage converter. The current-to-voltage converter 2 may, for example comprise a resistor, a capacitor, or a resistor and a capacitor coupled together in parallel. The current-to-voltage converter 2 may has an impedance $Z_{diff}$. The current-to-voltage converter 2 may have a first terminal which is coupled to the first input A and a second terminal, which is coupled to the second input B.

The current comparator circuit 10 further includes a switch 20. The switch may be opened and closed using a control signal, such as the control voltage Vsw shown in Figure 1. The switch 20 may have a first terminal which is coupled to the first input A and a second terminal, which is coupled to the second input B. Accordingly, the current-to-voltage converter 2 and the switch 20 are coupled in parallel between the first input A and the second input B. When the switch 20 is closed, the current-to-voltage converter 2 is shorted out of the circuit, and current can pass freely between the first input A and the second input B. On the other hand, when the switch 20 is open, current can pass between the first input A and second input B, via the current-to-voltage converter 2.

The current comparator circuit 10 also includes a first current branch and a second current branch. The first current branch has a current input terminal that is coupled to the first input A. The second current branch has a current input terminal that is coupled to the first input B.

As will be described below, the current comparator circuit 10 is operable in a first mode and in a second mode. In operation, the second mode typically occurs after the function of the first mode has been completed.

In the first mode, the switch 20 is closed, so as to short the first input A to the second input B as noted above. Because the inputs A and B are shorted together, the first mode causes an input voltage $V_{inm}$ at the first input A and an input voltage $V_{inp}$ at the second input B to be substantially equal to a common mode voltage $V_{incm}$ of the first and second inputs.

In the second mode, the switch 20 is opened. This causes a current $\Delta I$ to flow through the current-to-voltage converter 2. Consequently, a voltage $\Delta V$ appears across the first input A and the second input B.

Note that in both the first mode and the second mode, the current flowing through the first branch is substantially equal to the current flowing through the second branch (and is equal to $(I_1 + I_2)/2$).

Further optional details of the structure of a current comparator circuit 10 according to an embodiment of this disclosure will now be described with continued reference to Figure 1.

In some embodiments, the first current branch may include a first current conveyor 22a and a second current conveyor 22b. The first current conveyor 22a may be considered to be, or to form part of, a third branch of the current

5

comparator circuit 10. The second current conveyor 22b may be considered to be, or to form part of, a fourth branch of the current comparator circuit 10.

Similarly, the second current branch may include a third current conveyor 24a and a fourth current conveyor 24b. The third current conveyor 24a may be considered to be, or to form part of, a fifth branch of the current comparator circuit 10. The fourth current conveyor 24b may be considered to be, or to form part of, a sixth branch of the current comparator circuit 10.

Each current conveyor 22a, 22b, 24a, 24b may include one or more current conveying components 4a, 4b, 6a, 6b, respectively. As can be seen in Figure 1, the first current conveyor 22a can have a current input terminal 11a, a current output terminal 14a and a control terminal 8a. Similarly, the second current conveyor 22b can have a current input terminal 11b, a current output terminal 14b and a control terminal 18b. As can also be seen in Figure 1, the third current conveyor 24a can have a current input terminal 12a, a current output terminal 16a and a control terminal 18a. Similarly, the fourth current conveyor 24b can have a current input terminal 12b, a current output terminal 16b and a control terminal 8b. A current flowing through each current conveyor 22a, 22b, 24a, 24b may be controllable by a voltage applied to the control terminal 8a, 18b, 18a, 8b of that respective current conveyor 22a, 22b, 24a, 24b.

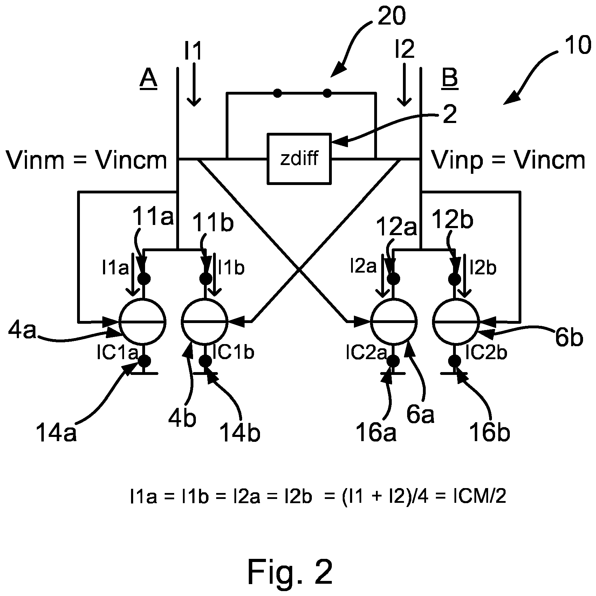

In the example shown in Figure 2:

- the control terminal 8a and the current input terminal 1 1a of the first current conveyor 22a is coupled to the first input A;
- the control terminal 18b of the second current conveyor 22b is coupled to the second input B;
- the current input terminal 11b of the second current conveyor 22b is coupled to the first input A;
- the control terminal 18a of the third current conveyor 24a is coupled to the first input A;
- the current input terminal 12a of the third current conveyor 24a is coupled to the second input B, and
- the control terminal 8b and the current input terminal 12b of the fourth current conveyor 24b is coupled to the second input B.

The current output terminal 14a, 14b, 16a, 16b of each respective current conveyor 22a, 22b, 24a, 24b may be coupled to a reference potential. The reference potential may, for instance, be ground.

To provide for a balanced operation of the current conveyor parts of the current comparator circuit 10, the component(s) 4a, 4b, 6a, 6b of each current conveyor 22a, 22b, 24a, 24b may be configured such that they have substantially the same voltage-to-current gain characteristics. Moreover, in some embodiments, the voltage-to-current gain of each current conveyor 22a, 22b, 24a, 24b may be substantially constant in a least a portion of the variation range of the control voltages provided at the control terminals 8a, 18b, 18a, 8b (e.g., $I(dV) = -I(-dV)$).

It will be appreciated that the circuit layout of the current conveyor part of the current comparator circuit 10 may be implemented in a number of different ways, and that the connections and components of the current conveyor parts described here in relation to Figure 1 are merely provided as an example.

The operation of the current comparator circuit 10 in the first mode will now be described with reference to Figure 2 and with continued reference to Figure 1. The first mode may be referred to as a biasing self-adjustment mode of the current comparator circuit 10.

In a first mode, the switch 20 is closed to detect and generate a common mode current based on the first and second currents $I_1$, $I_2$. Subsequently, in the second mode, the switch 20 will be opened, and a differential voltage will be generated at the input of the first and second branch, in relation to the difference between the first and second currents $I_1$, $I_2$.

A benefit of a current comparator circuit 10 according to embodiments of this disclosure is that the current comparator circuit 10 can first automatically detect and generate the common mode current before providing a differential voltage $\Delta V$ reflecting the difference between the two input currents $I_1$, $I_2$. The automatic setting of the common mode current can prevent large variations of the common mode voltages which could otherwise impact the accuracy of the comparison over a large range of temperatures and/or process variations. The fully differential operation (differential-input and differential-out) provided by some embodiments of this disclosure can allows an accurate comparison of the two input currents $I_1$, $I_2$ to be made.

As shown in Figure 1, the voltages applied to the control terminals 8a, 18b, 18a, 8b of the first 22a, second 22b, third 24a and fourth 24b current conveyors may be denoted as $V_{C1a}$, $V_{C1b}$, $V_{C2a}$ and $V_{C2b}$, respectively. As also shown in Figure 1, the currents flowing through the first 22a, second 22b, third 24a and fourth 24b current conveyors may be denoted as $I_{1a}$, $I_{1b}$, $I_{2a}$ and $I_{2b}$, respectively.

In the first mode, with the switch 20 closed, it can be seen that each current conveyor 22a, 22b, 24a, 24b receive the same signal on their control terminal, i.e.:

$$V_{C1a} = V_{C1b} = V_{C2a} = V_{C2b}$$

In the first mode, the biasing current of the current conveyors 22a, 22b, 24a, 24b is then automatically adjusted following the common mode current $I_{CM}$ of the input currents:

$$I_{1a} = I_{1b} = I_{2a} = I_{2b} = I_{CM}/2 = (I_1+I_2)/4$$

where $I_{CM}$ is a common mode current of the first input A and the second input B (i.e., $I_{CM} = (I_1+I_2)/2$). Accordingly, in the first mode, in which the switch 20 is closed, each of the four current conveyors 22a, 22b, 24a, 24b may drive a current that is substantially equal to the sum of the currents received at the first input A and the second input B divided by four.

This approach brings a benefit that, contrary to some prior solutions, current comparator circuits according to embodiments of this disclosure are not necessarily limited in the operating range by a predefined biasing current.

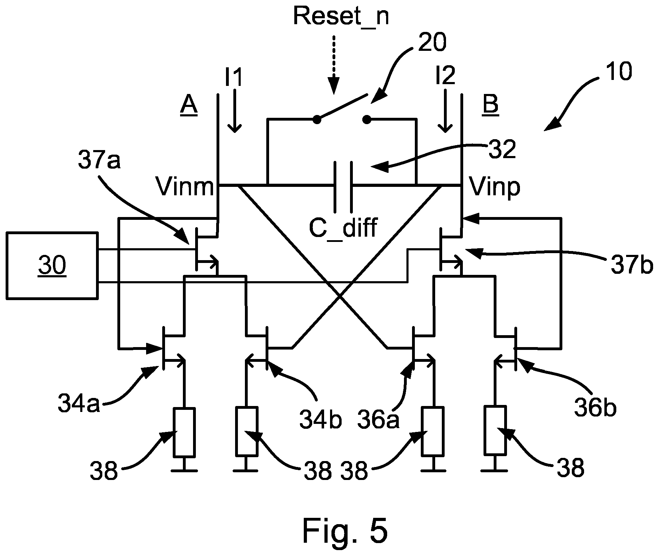

Furthermore, at transistor level (e.g., see Figure 5), embodiments of this disclosure do not require the use of a common mode feedback loop, which may otherwise complicate the implementation, and which may limit the speed of operation.

As noted above, at the end of the first mode, the voltages $V_{inm}$ and $V_{inp}$ at the inputs A and B, respectively, are equal to a common mode voltage $V_{incm}$.

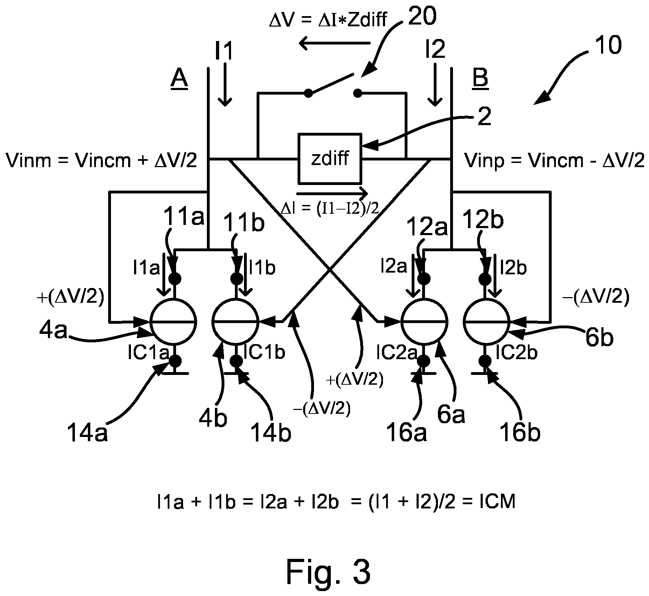

The operation of the current comparator circuit 10 in the second mode will now be described with reference to Figure 3 and with continued reference to Figure 1. The second mode may be referred to as a comparison mode - it is in this mode that the input currents Ii and $I_2$ may be compared.

As noted previously, in the second mode, the switch 20 is open, whereby a current $\Delta I$ starts to flow through the current-to-voltage converter 2. This causes a voltage $\Delta V$ to appear across the first input A and the second input B (as shown in Figure 3, $\Delta V = \Delta I * Z_{diff}$). In the present embodiment, this voltage $\Delta V$ is built up across the current-to-voltage converter 2.

This change in behaviour of the current comparator circuit 10, following the opening of the switch 20 causes the voltages $V_{inm}$ and $V_{inp}$ at the inputs A and B to become $V_{inm}$ = Vincm + $\Delta V$/2 and $V_{inp}$ = Vincm - $\Delta V$/2, respectively (these voltages are also denoted in Figure 3). Accordingly, $V_{C1a}$ and $V_{C2a}$ will vary by an amount $+\Delta V$/2. This in turn creates changes $\delta I_{1a}$ and $\delta I_{2a}$ in the currents $I_{1a}$ and $I_{2a}$ which are proportional to $+\Delta V$/2. Accordingly, also, $V_{C1b}$ and $V_{C2b}$ will vary by $-\Delta V$/2. This in turn creates changes $\delta I_{1b}$ and $\delta I_{2b}$ in $I_{1b}$ and $I_{2b}$ which are proportional to $-\Delta V$/2. Note that because, as noted above, the current conveyors 22a, 22b ,24a, 24b have the same characteristics:

$$\delta I_{1a} = -\delta I_{1b} \text{ and } \delta I_{2a} = -\delta I_{2b}$$

Therefore, the sum $I_{1a} + I_{1b}$ remains identical to that in the first mode (= $I_{CM}$), as does the sum $I_{2a} + I_{2b}$:

$$I_{1a} + I_{1b} = I_{2a} + I_{2b} = I_{CM}.$$

Accordingly, the current through the current-to-voltage converter 2 is given by:

$$\Delta I = I_1 - (I_{1a} + I_{1b}) = I_1 - I_{CM} = I_1 - (I_1 + I_2)/2 = (I_1 - I_2)/2$$

The same result arises when calculating based upon the current at the input B:

$$\Delta I = -I_2 + (I_{2a} + I_{2b}) = -I_2 + I_{CM} = -I_2 + (I_1 + I_2)/2 = (I_1 - I_2)/2$$

Note that $\Delta I$ is is proportional to the difference between the currents Ii and $I_2$, as is the differential voltage $\Delta V$ between the inputs A and B (assuming linear behaviour of the current-to-voltage converter 2).

In accordance with embodiments of this disclosure, the value of $\Delta V$ can be evaluated in the second mode, so as to determine information regarding $I_1$ and $I_2$. By way of example, in some embodiments, in the second mode, $\Delta V$ = 0 is indicative of $I_1$ being equal to $I_2$, whereas $\Delta V \neq 0$ is indicative of $I_1$ not being equal to $I_2$. In some embodiments, a voltage comparator and/or voltage amplifier may be coupled across the first input A and the second input B to assist in determining $\Delta V$ in the second mode (e.g., by amplifying and converting the differential voltage to a single ended voltage.

By way of example only, when using a capacitor as the current-to-voltage converter 2, the current difference ($I_1 - I_2$) may be integrated and may generate a linearly growing voltage ($\Delta V = \int (I1 - I2)dt$) over time. This may be considered to be equivalent to a high gain comparator if we allow a certain time to pass before the point at which $\Delta V$ is evaluated.

As the proposed cross-coupling structure does not form a negative feedback loop (this is because the sum of the current ($I_{1a} + I_{1b}$) is substantially constant and substantially independent of the voltage across the inputs A and B (the same being true for ($I_{2a} + I_{2b}$)), the current comparator circuit 10 does not suffer from false detections due to charge injection from the switch 20. It is envisaged that the capacitor forming the current-to-voltage converter 2 may, in some embodiments, comprise a parasitic capacitance at the inputs A and B.

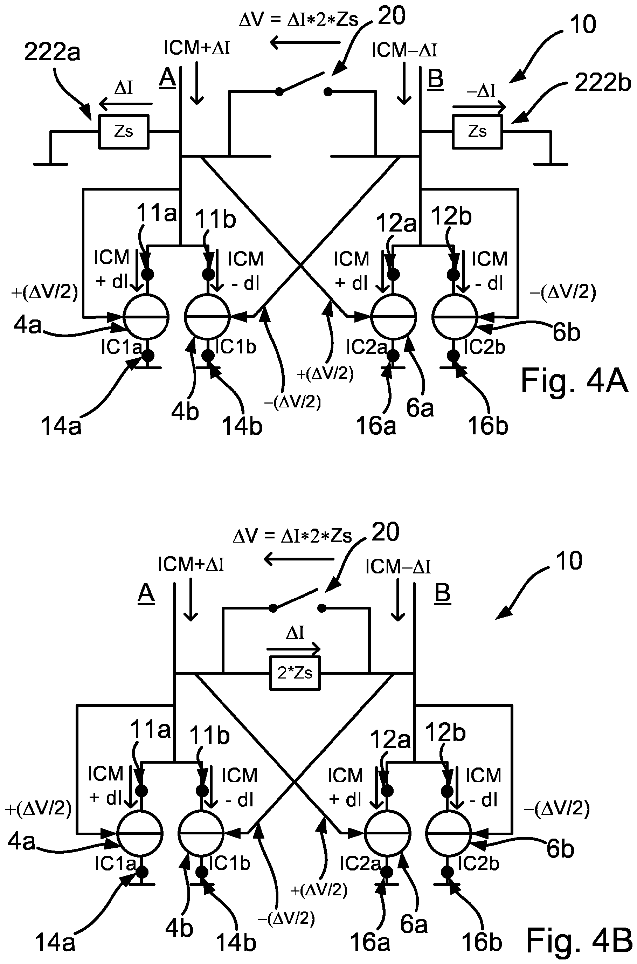

Turning now to Figures 4A and 4B, another embodiment of a current comparator circuit 10 according to this disclosure will now be described. In the embodiment shown in Figure 4A, instead of having a current-to-voltage converter 2 and switch 20 coupled in parallel between the first input A and the second input B, the current comparator circuit 10 includes a current comparator that includes a first current-to-voltage converter component 222a and a second current-to-voltage converter component 222b. The switch 20 in this embodiment remains coupled between the first input and the second input B as already described above. Each current-to-voltage converter component 222a, 222b may comprise one of: a capacitor; a resistor, and a capacitor in parallel with a resistor. As shown in Figure 4A, a terminal of each current-to-voltage converter component 222a, 222b opposite to the respective current input (A, B) may be coupled to a reference potential (e.g., ground).

Accordingly, unlike the embodiments described in relation to Figures 1 to 3, the embodiment of Figure 4A uses single-ended impedances. This may occur intentionally, by the provision of separate components in the circuit (e.g., the capacitor(s) and/or resistor(s) noted above), or naturally, by virtue of the presence of parasitic impedances (e.g., between the inputs A, B and ground). In either case, the current comparator circuit 10 may operate as already described above in respect of the differential current-to-voltage converter 2. In this respect, Figures 4A and 4B (the latter of which shows an embodiment of the kind having a differential current-to-voltage converter) have been marked up with various voltages and currents, which demonstrate that the equivalent operation of a current comparator circuit 10 involving current-to-voltage converters with single-ended or differential impedances.

Further optional details of a current comparator circuit 10 according to some embodiments of this disclosure will now be described with reference to Figure 5. It will be appreciated that the components described below in relation to Figure 5 may be used to implement embodiments of the kind shown in Figures 1, 2, 3, 4b and 6 (in which the current-to-voltage converter 2 is coupled in parallel with the switch 20) but also embodiments of the kind shown in Figure 4A (albeit that embodiments of the kind shown in Figure 4A would not include the capacitor 32 described below, but instead would have separate current-to-voltage converter components 222a, 222b coupled to the inputs A, B).

In Figure 5, the current-to-voltage converter 2 comprises a capacitor C_diff 32, and the one or more current conveying components 4a, 4b, 6a and 6b or each respective current conveyor 22a, 22b, 24a, 24b each comprise a transistor 34a, 34b, 36a, 36b (e.g., field effect transistors such as NMOS or PMOS, although NMOS is used in the example of Figure 5). In this embodiment, the control terminal 8a, 18b, 18a, 8b of each current conveyor 22a, 22b, 24a, 24b may comprise the gate of the transistor 34a, 34b, 36a, 36b of that respective current conveyor 22a, 22b, 24a, 24b. The current input terminal 11a, 11b, 12a, 12b of each current conveyor 22a, 22b, 24a, 24b may comprise a drain of the transistor 34a, 34b, 36a, 36b of that respective current conveyor 22a, 22b, 24a, 24b. The current output terminal 14a, 14b, 16a, 16b of each current conveyor 22a, 22b, 24a, 24b may comprise a source of the transistor 34a, 34b, 36a, 36b of that respective current conveyor 22a, 22b, 24a, 24b. As shown in Figure 5, the source of each transistor 34a, 34b, 36a, 36b may be coupled to a reference voltage (e.g., ground, as noted above) via a respective resistor 38.

In Figure 5, a cascode transistors 37a, 37b are provided (e.g., field effect transistors such as NMOS or PMOS, although NMOS is used in the example of Figure 5).

The cascode transistor 37a has a first current terminal (e.g., source) that is coupled to the current input terminals 11a, 11b of the current conveyors 22a, 22b (implemented by coupling the first current terminal of the transistor 37a to the drains of the transistors 34a, 34b in this embodiment). The cascode transistor 37a also has a second current terminal (e.g., drain) that is coupled to the first input A.

Similarly, the cascode transistor 37b has a first current terminal (e.g., source) that is coupled to the current input terminals 12a, 12b of the current conveyors 24a, 24b (implemented by coupling the first current terminal of the transistor 37b to the drains of the transistors 36a, 36b in this embodiment). The cascode transistor 37b also has a second current terminal (e.g., drain) that is coupled to the second input B.

The cascode transistors 37a, 37b each have a control terminal (e.g., gate), which is coupled to a cascode and gain boost controller 30.

The addition of the cascode transistors 37a, 37b can allow an increase of the impedance and can reduce the influence of the current conveyors 22a, 22b, 24a, 24b on the differential current-to-voltage converter 2 (the capacitor c_diff 32 in this example). The use of a capacitor for the differential current-to-voltage converter 2 in this embodiment can reduce the noise and increase the gain of the converter. Indeed, the differential voltage across the capacitor 32 increases (or decreases) linearly over time and proportionally to the current difference ($I_1 - I_2$).

According to embodiments of this disclosure, a method of comparing a first current (e.g., a reference current as noted above) with a second current (e.g., a current to be calibrated by comparison with the reference current) can be provided. The method may involve providing a current comparator circuit of the kind described herein. The method may also include operating the current comparator circuit in the first mode with the switch closed. The method may further include operating the current comparator circuit in the second mode with the switch open. The method may also include determining $\Delta V$ in the second mode. The method may further include comparing the first current with the second current based upon the value of $\Delta V$.

Accordingly, there has been described a current comparator circuit and method. The circuit includes a first input and a second input to receive currents $I_1$ and $I_2$. The circuit includes a current-to-voltage converter and a switch. The circuit includes a first and second current branches comprising a current input terminals coupled to the first input and the second input. In a first mode the switch is closed to cause an input voltage at the first input and at the second input to be equal. In a second mode the switch is opened whereby a current flows through the current-to-voltage converter and voltage $\Delta V$ appears across the first input and the second input. In both the first mode and the second mode, the current flowing through the first branch and the current flowing through the second branch are equal to $(I_1 + I_2)/2$.

Although particular embodiments of this disclosure have been described, it will be appreciated that many modifications/additions and/or substitutions may be made within the scope of the claims.

**Claims**

1. A current comparator circuit comprising:

   a first input operable to receive a first current $I_1$ and a second input operable to receive a second current $I_2$,
   a current-to-voltage converter coupled to the first input and to the second input;
   a switch coupled between the first input and the second input;
   a first current branch comprising a current input terminal coupled to the first input;
   a second current branch comprising a current input terminal coupled to the second input;
   wherein the current comparator circuit is operable in a first mode followed by a second mode,
   wherein, in the first mode the switch is closed to short the first input to the second input, wherein the first mode causes an input voltage $V_{inm}$ at the first input and an input voltage $V_{inp}$ at the second input to be substantially equal to a common mode voltage $V_{incm}$ of the first and second inputs,
   wherein, in the second mode the switch is opened whereby a current $\Delta I$ flows through the current-to-voltage converter and a voltage $\Delta V$ appears across the first input and the second input, and
   wherein, in both the first mode and the second mode, the current flowing through the first branch is substantially equal to the current flowing through the second branch and equal to $(I_1 + I_2)/2$.

2. The current comparator circuit of claim 1, wherein the current-to-voltage converter and the switch are coupled in parallel between the first input and the second input.

3. The current comparator circuit of claim 1, wherein the current-to-voltage converter comprises a first current-to-voltage converter component coupled to the first input and a second current-to-voltage converter component coupled to the second input.

4. The current comparator circuit of any preceding claim, wherein:

   the first current branch comprises a first current conveyor and a second current conveyor;
   the second current branch comprises a third current conveyor and a fourth current conveyor;
   wherein each current conveyor comprises a current input terminal, a current output terminal, and a control terminal, wherein a current flowing through each current conveyor is controllable by a voltage applied to the control terminal of that current conveyor,
   wherein:

   the control terminal and the current input terminal of the first current conveyor is coupled to the first input;
   the control terminal of the second current conveyor is coupled to the second input;
   the current input terminal of the second current conveyor is coupled to the first input;
   the control terminal of the third current conveyor is coupled to the first input;
   the current input terminal of the third current conveyor is coupled to the second input, and
   the control terminal and the current input terminal of the fourth current conveyor is coupled to the second input,

   wherein in the first mode:

$$V_{C1a} = V_{C1b} = V_{C2a} = V_{C2b} \; ;$$

and

$$I_{1a} = I_{1b} = I_{2a} = I_{2b} = I_{CM}/2 = (I_1 + I_2)/4$$

where $I_{1a}$, $I_{1b}$, $I_{2a}$, $I_{2b}$ are the currents flowing through the first, second, third and fourth current conveyors, respectively, where $V_{C1a}$, $V_{C1b}$, $V_{C2a}$, and $V_{C2b}$ are voltages applied to the control terminals of the first, second, third and fourth current conveyors, and where $I_{CM}$ is a common mode current of the first input and the second input, and
wherein, in the second mode :

$\Delta V = 0$ is indicative of $I_1$ being equal to $I_2$ and wherein $\Delta V \neq 0$ is indicative of $I_1$ not being equal to $I_2$;
$V_{inm} = V_{incm} + \Delta V/2$, whereby $V_{C1a}$ and $V_{C2a}$ vary by $+\Delta V/2$ which creates changes $\delta I_{1a}$ and $\delta I_{2a}$ in $I_{1a}$ and $I_{2a}$ proportional to $+\Delta V/2$;
$V_{inp} = V_{incm} - \Delta V/2$, whereby $V_{C1b}$ and $V_{C2b}$ vary by $-\Delta V/2$ which creates changes $\delta I_{1b}$ and $\delta I_{2b}$ in $I_{1b}$ and $I_{2b}$ proportional to $-\Delta V/2$;
where $\delta I_{1a} = -\delta I_{1b}$ and where $\delta I_{2a} = -\delta I_{2b}$ , whereby $I_{1a} + I_{1b} = I_{2a} + I_{2b} = I_{cM}$ ;

$$\Delta I = I_1 - (I_{1a} + I_{1b}) = I_1 - I_{CM} = I_1 - (I_1 + I_2)/2 = (I_1 - I_2)/2 ;$$

and

$$\Delta I = -I_2 + (I_{2a} + I_{2b}) = -I_2 + I_{CM} = -I_2 + (I_1 + I_2)/2 = (I_1 - I_2)/2 ,$$

where $I_{CM}$ is a common mode current of the first input and the second input.

5. The current comparator circuit of claim 4, wherein the current output terminal of each current conveyor is coupled to a reference potential.

6. The current comparator circuit of claim 5, wherein the reference potential is ground.

7. The current comparator circuit of any of claims 4 to 6, wherein the first current is a reference current and wherein the second current is a current to be calibrated against the reference current.

8. The current comparator circuit of any preceding claim, wherein each current conveyor has substantially the same voltage-to-current gain characteristic.

9. The current comparator circuit of any preceding claim, further comprising a voltage amplifier coupled across the first input and the second input for determining $\Delta V$ in the second mode.

10. The current comparator circuit of any preceding claim, wherein each current conveyor comprises a transistor, wherein:

the control terminal of the current conveyor comprises a gate of the transistor; and
the current input terminal of the current conveyor comprises a drain of the transistor.

11. The current comparator circuit of claim 10, wherein each current conveyor further comprises a resistor coupled to a source of the transistor.

12. The current comparator circuit of any preceding claim, wherein:

in the second mode, in which the switch is open, a difference in current between the current received at the first input and the current received at the second input flows through the current-to-voltage converter; and/or
in the first mode, in which the switch is closed, each of the four current conveyor drives a current substantially equal to the sum of the currents received at the first and second input divided by four.

13. The current comparator circuit of any preceding claim, wherein the current-to-voltage converter or each current-to-voltage converter component comprises one of:

a capacitor;
a resistor, and
a capacitor in parallel with a resistor.

14. A digital to analogue converter, DAC, comprising a plurality of current sources and at least one current comparator circuit according to any preceding claim for calibrating the current sources.

15. A method of comparing a first current with a second current, the method comprising:

providing a current comparator circuit according to any of claims 1 to 15;
operating the current comparator circuit in the first mode with the switch closed;
operating the current comparator circuit in the second mode with the switch open;
determining $\Delta V$ in the second mode, and
comparing the first current with the second current based upon the value of $\Delta V$.

Fig. 1

I1a = I1b = I2a = I2b = (I1 + I2)/4 = ICM/2

Fig. 2

$\Delta V = \Delta I * Zdiff$ 20

I1

A

$Vinm = Vincm + \Delta V/2$

zdiff

10

2

$Vinp = Vincm - \Delta V/2$

I2

B

$\Delta I = (I1 - I2)/2$

11a 11b

I1a I1b

12a 12b

I2a I2b

$+(\Delta V/2)$

4a

IC1a

$-(\Delta V/2)$

6b

14a

4b

14b

$+(\Delta V/2)$

$-(\Delta V/2)$

IC1b

IC2a

16a

6a

IC2b

16b

I1a + I1b = I2a + I2b = (I1 + I2)/2 = ICM

Fig. 3

Fig. 4A

Fig. 4B

Fig. 5

Europäisches
Patentamt

European
Patent Office

Office européen
des brevets

**EUROPEAN SEARCH REPORT**

**Application Number**

EP 24 30 6030

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/200358 A1 (KUANG YU [TW] ET AL) 9 August 2012 (2012-08-09) | 1-3,8-15 | INV. H03K5/24 |
| A | * paragraph [0003] - paragraph [0060]; figures 1-12B * ----- | 4-7 | ADD. H03F3/45 |
| A | EP 3 672 077 A1 (SOCIONEXT INC [JP]) 24 June 2020 (2020-06-24) * paragraph [0005] - paragraph [0043]; figures 1-7 * ----- | 1-15 | |
| A | US 2015/015307 A1 (SHU YUN-SHIANG [TW]) 15 January 2015 (2015-01-15) * paragraph [0002] - paragraph [0154]; figures 1-8 * ----- | 1-15 | |

|  |
|---|
| **TECHNICAL FIELDS SEARCHED (IPC)** |
| H03K H03F |

The present search report has been drawn up for all claims

| Place of search | Date of completion of the search | Examiner |
|---|---|---|
| Munich | 10 December 2024 | Kassner, Holger |

EPO FORM 1503 03.82 (P04C01)

## ANNEX TO THE EUROPEAN SEARCH REPORT
## ON EUROPEAN PATENT APPLICATION NO.

EP 24 30 6030

This annex lists the patent family members relating to the patent documents cited in the above-mentioned European search report.
The members are as contained in the European Patent Office EDP file on
The European Patent Office is in no way liable for these particulars which are merely given for the purpose of information.

10-12-2024

| Patent document cited in search report | | | Publication date | Patent family member(s) | | Publication date |
|---|---|---|---|---|---|---|
| US 2012200358 | A1 | | 09-08-2012 | CN | 102629865 A | 08-08-2012 |
| | | | | TW | 201234780 A | 16-08-2012 |
| | | | | US | 2012200358 A1 | 09-08-2012 |
| EP 3672077 | A1 | | 24-06-2020 | EP | 3672077 A1 | 24-06-2020 |
| | | | | US | 2020204184 A1 | 25-06-2020 |
| US 2015015307 | A1 | | 15-01-2015 | CN | 103208981 A | 17-07-2013 |
| | | | | CN | 105262465 A | 20-01-2016 |
| | | | | TW | 201320605 A | 16-05-2013 |
| | | | | US | 2013154737 A1 | 20-06-2013 |
| | | | | US | 2015015307 A1 | 15-01-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5446397 A
- US 5770954 A
- US 6275075 B
- US 6424183 B
- US 7583108 B
- US 9841443 B

**Non-patent literature cited in the description**

- 1.5GHz fully differential latched current comparator with 20mA of sensitivity. **V. GIANNINI** ; **J. CRA-NINCKX** ; **B. COME** ; **P. MALCOVATI** ; **A. BASCHIR-OTTO**. Ph.D. Research in Microelectronics and Electronics. IEEE, 2006
- **SANTANU SARKAR** ; **SWAPNA BANERJEE**. 500MHz differential latched current comparator for calibration of current steering DAC. *Proceedings of the 2014 IEEE Students' Technology Symposium*
- A full differential low voltage low power high speed current comparator. **G. ROIENTAN LAHIJI** ; **F. REZVAN**. ICM 2000. Proceedings of the 12th International Conference on Microelectronics. IEEE
- **A. R. SERAZETDINOV** ; **E. V. ATKIN**. Differential Input Area Efficient Current Comparator. *Proceedings 2019 IEEE 31st International Conference on Microelectronics (MIEL), Nis, Serbia*, 16 September 2019
- **CARLOS A. DE LA CRUZ BLAS et al.** CMOS Latch Based on a Class-AB Transconductor. *20th European Conference on Circuit Theory and Design (ECCTD)*, 2011